# EUROPÄISCHE PATENTSCHRIFT

(11) **EP 1 634 340 B1**
(45) Veröffentlichungstag und Bekanntmachung des Hinweises auf die Patenterteilung: **25.04.2007**
(21) Anmeldenummer: 04725875.1
(22) Anmeldetag: 06.04.2004
(51) Int. Cl.: H01L 41/053, H01L 41/24, F16F 1/02

(54) **ROHRFEDER FÜR AKTOR UND VERFAHREN ZUR MONTAGE DER ROHRFEDER**
TUBE SPRING FOR AN ACTUATOR, AND METHOD FOR MOUNTING SAID TUBE SPRING
TUBE-RESSORT CONCU POUR UN ACTIONNEUR, ET PROCEDE DE MONTAGE DE CE TUBE-RESSORT

(30) Priorität: 04.06.2003 DE 10325283; 09.03.2004 DE 102004011455
(43) Veröffentlichungstag der Anmeldung: 15.03.2006
(73) Patentinhaber: ROBERT BOSCH GMBH, 70442 Stuttgart (DE)
(72) Erfinder: DEPONTE, Rene, 71093 Weil im Schoenbuch (DE); STIER, Hubert, 71665 Vaihingen/Enz (DE); SCHMIEDER, Dietmar, 71706 Markgroeningen (DE)
(74) Vertreter: Körfer, Thomas
(86) Internationale Anmeldenummer: PCT/DE2004/000712
(87) Internationale Veröffentlichungsnummer: WO 2004/109818

(56) Entgegenhaltungen:
- WO-A-99/08330
- WO-A-02/079636
- CH-A- 434 802
- DE-A- 10 035 168
- DE-A- 10 310 787
- DE-A- 19 650 900

## Beschreibung

### Stand der Technik

Die Erfindung geht aus von einer Rohrfeder für einen Aktor nach der Gattung des Anspruchs 1 und einem Verfahren zur Montage der erfindungsgemäßen Rohrfeder nach der Gattung des Anspruchs 13 oder 17.

Üblicherweise werden piezoelektrische oder magnetostriktive Aktoren zur Betätigung von Brennstoffeinspritzventilen für Brennstoffeinspritzanlagen von Brennkraftmaschinen zur Vermeidung von Zug- und Scherkräften durch eine Feder vorgespannt. Gewöhnlich wird zur Erzeugung der Vorspannung die auch bei geschlossenem Brennstoffeinspritzventil vorhandene Restspannung der Rückstellfeder des Brennstoffeinspritzventils genutzt.

Beispielsweise ist aus der DE 199 51 012 A1 ein Aktor, insbesondere zur Betätigung von Brennstoffeinspritzventilen für Brennstoffeinspritzanlagen von Brennkraftmaschinen, bekannt, welcher mehrere gestapelt angeordnete Schichten aus einem piezoelektrischen oder magnetostriktiven Material aufweist. Der Aktor wird durch einen in einer zentralen Ausnehmung angeordneten Zuganker mittels gegenläufiger Gewinde vorgespannt. Die Fixierung und Kraftübertragung erfolgt über eine Deckplatte und eine Bodenplatte.

Nachteilig an dieser Bauform ist dabei insbesondere die Notwendigkeit, den Stapelaktor hohl zu gestalten, um den Zuganker in der Ausnehmung unterbringen zu können. Dadurch wird der Aktor noch beschädigungsanfälliger bei Vormontage und Montage.

Weiterhin ist aus der WO 99/08330 A1 ein piezoelektrischer Aktor bekannt, der in eine Federhülse eingeschoben und vorgespannt mit zwei Enden der Federhülse kraft- und/oder formschlüssig verbunden wird. Dadurch wird eine Baueinheit hergestellt, bei der die Vorspannkraft des piezoelektrischen Aktors dauerhaft festgelegt ist.

Nachteilig an diesem Aktor ist insbesondere, daß die Vorspannung des Aktors allein durch die Elastizität der Federhülse vorgegeben ist. Ein progressives Verhalten zur Kompensation von kurzen Ansteuerzeiten kann damit nicht erreicht werden.

DE 100 35 168 A1 beschreibt ein Dosierventil zur Dosierung eines unter Druck stehenden Dosierfluids, welches einen Ventilraum mit einem Ventilgehäuse zur Aufnahme einer Ventilnadel aufweist. Die Ventilnadel ist mit einem Stellantrieb verbunden und wird über diesen bewegt. Der Stellantrieb weist einen Piezoaktor auf, der in einer von einem Gehäuse begrenzten Aktorkammer angeordnet ist, wobei der Piezoaktor einen Aktorstapel aufweist und der Aktorstapel mit seinen Stirnseiten zwischen einem Deckelement und einem Bodenelement eingespannt ist. Der Aktorstapel wird von einer in der Aktorkammer vorgesehenen Hydraulikflüssigkeit umspült.

### Vorteile der Erfindung

Die erfindungsgemäße Rohrfeder für einen Aktor mit den Merkmalen des Anspruchs 1 und die erfindungsgemäße Verfahren zur Montage mit den Merkmalen der Ansprüche 13 und 16 haben demgegenüber den Vorteil, daß Montageeingriffe in der Rohrfeder eine gleichmäßige Vorspannung der Rohrfeder und des Aktors und eine spannungsfreie Verschweißung der Rohrfeder mit dem Aktorkopf und dem Aktorfuß ermöglichen.

Durch die in den Unteransprüchen aufgeführten Maßnahmen sind vorteilhafte Weiterbildungen und Verbesserungen der im Anspruch 1 angegebenen Rohrfeder sowie der in den Ansprüchen 13 und 16 angegebenen Verfahren möglich.

Vorteilhafterweise sind die Montageeingriffe in zumindest einem der ansonsten geschlossenen Endbereiche der Rohrfeder angeordnet. Dadurch wird einerseits die Federcharakteristik der Rohrfeder nicht negativ beeinflußt. Eine positive Beeinflussung mit größerem möglichen Aktorhub ist durch die Einbringung der Montageeingriffe in nur einem Endbereich möglich.

Weiterhin ist von Vorteil, daß die Montageeingriffe symmetrisch und paarig bzw. äquidistant in gleichen Winkelabständen an der Rohrfeder angeordnet sind, so daß eine gleichmäßige Verspannung möglich ist.

Zudem ist vorteilhaft, daß zunächst eine Vormontage des Aktormoduls in spannungsfreiem Zustand durchgeführt wird, bevor das Aktormodul zur Vorspannung und Endmontage in eine Montagevorrichtung eingesetzt wird. Dadurch ist der Aktor bereits vor Beschädigungen durch Scherkräfte geschützt und kann bis zur Weiterverarbeitung gelagert und transportiert werden.

### Zeichnung

Ausführungsbeispiele der Erfindung sind in der Zeichnung vereinfacht dargestellt und in der nachfolgenden Beschreibung näher erläutert. Es zeigen:
- Fig. 1: eine stark schematisierte Darstellung eines für die Bestückung mit einer erfindungsgemäßen Rohrfeder geeigneten Brennstoffeinspritzventils;
- Fig. 2: eine Aufsicht auf die zur Herstellung der Rohrfeder vorbereitete Platine gemäß einem ersten Ausführungsbeispiel;
- Fig. 3: eine schematische Darstellung der zur Montage einer erfindungsgemäß ausgestalteten Rohrfeder gemäß Fig. 2 benötigten Montageschritte;
- Fig. 4: eine perspektivische Ansicht der fertig montierten erfindungsgemäß ausgestalteten Rohrfeder gemäß Fig. 2 und 3,

- Fig. 5: eine Aufsicht auf die zur Herstellung der Rohrfeder vorbereitete Platine gemäß einem zweiten Ausführungsbeispiel;
- Fig. 6: eine Ansicht der rundgebogenen Platine der erfindungsgemäß ausgestalteten Rohrfeder gemäß Fig. 6, und
- Fig. 7A-B: eine schematische Darstellung der fertig montierten erfindungsgemäß ausgestalteten Rohrfeder gemäß Fig. 5 und 6 in einer geschnittenen und einer seitlichen Darstellung.

### Beschreibung der Ausführungsbeispiele

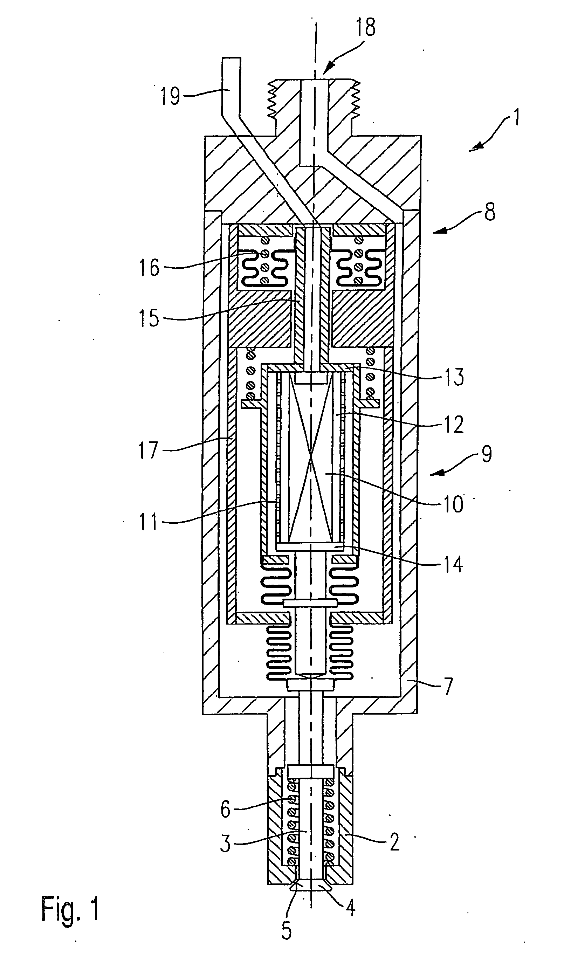

Fig. 1 zeigt zur besseren Verständlichkeit der Erfindung in einer stark schematisierten Darstellung ein zur Bestückung mit einer erfindungsgemäß ausgestalteten Rohrfeder geeignetes Brennstoffeinspritzventil.

Das in Fig. 1 dargestellte Brennstoffeinspritzventil 1 ist insbesondere als Brennstoffeinspritzventil 1 zum direkten Einspritzen von Brennstoff in einen nicht näher dargestellten Brennraum einer Brennkraftmaschine geeignet.

Das Brennstoffeinspritzventil 1 umfaßt einen Düsenkörper 2, in dem eine Ventilnadel 3 geführt ist. Diese weist an einem abströmseitigen Ende einen Ventilschließkörper 4 auf, welcher mit einer Ventilsitzfläche 5 einen Dichtsitz bildet. Das Brennstoffeinspritzventil 1 ist als nach außen öffnendes Brennstoffeinspritzventil 1 ausgebildet. Eine im Düsenkörper 2 angeordnete Rückstellfeder 6 beaufschlagt die Ventilnadel 3 so, daß das Brennstoffeinspritzventil 1 in der Ruhephase geschlossen gehalten bzw. die Ventilnadel 3 nach der Öffnungsphase in ihre Ruhestellung zurückgestellt wird.

Der Düsenkörper 2 mündet in ein Gehäuse 7 ein, in welchem ein hydraulischer Koppler 8 und ein Aktormodul 9 angeordnet sind.

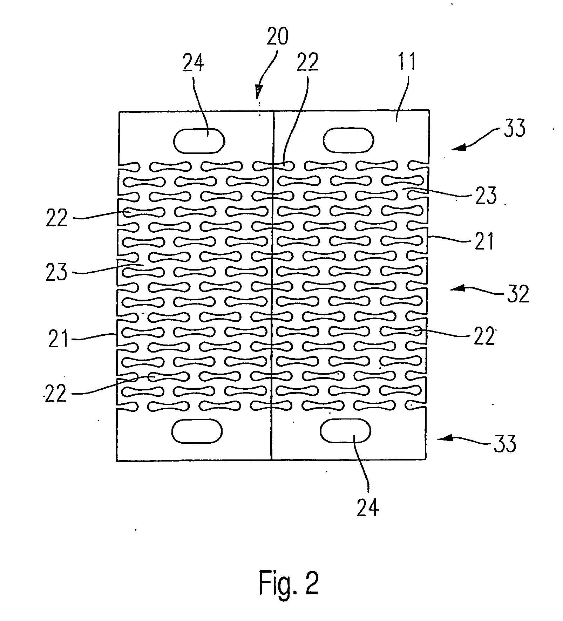

Das Aktormodul 9 umfaßt einen vorzugsweise piezoelektrischen Stapelaktor 10, welcher durch eine erfindungsgemäß ausgestaltete Rohrfeder 11 zum Schutz vor Scherkräften vorgespannt wird. Der Aktor 10 ist im vorliegenden Ausführungsbeispiel zusätzlich durch eine Umspritzung 12 geschützt. Der Aktor 10 weist einen Aktorfuß 13 und einen Aktorkopf 14 auf, welche mit der Rohrfeder 11 beispielsweise verschweißt sind. Die Rohrfeder 11 sowie die Bauteile des Aktors 10 werden weiter unten unter Bezugnahme auf die Fig. 2 bis 4 näher beschrieben.

Der hydraulische Koppler 8, welcher zuströmseitig des Aktormoduls 9 angeordnet ist, umfaßt einen Arbeitskolben 15, welcher durch eine Kopplerfeder 16 gegenüber dem Gehäuse 7 vorgespannt ist. Der hydraulische Koppler 8 übersetzt den geringen Hub des piezoelektrischen Aktors 10 in einen größeren Hub der Ventilnadel 3.

Der Koppler 8 und das Aktormodul 9 sind in einem Aktorgehäuse 17 gekapselt. Dieses wird von dem zentral über einen Zulaufstutzen 18 zugeführten Brennstoff umströmt, welcher durch das Gehäuse 7 sowie durch den Düsenkörper 2 zum Dichtsitz strömt. Das Brennstoffeinspritzventil 1 ist über einen elektrischen Steckkontakt 19 betätigbar.

Um bei der Montage sowie beim Betrieb des Aktors 10 sicherzustellen, daß Scherkräfte, welche zur Zerstörung des Aktors 10 führen können, vermieden werden, ist der Aktor 10 in der Rohrfeder 11 gekapselt. Diese spannt den Aktor 10 vor, so daß dieser durch die auf ihn wirkenden ausschließlich axialen Kräfte stabilisiert wird.

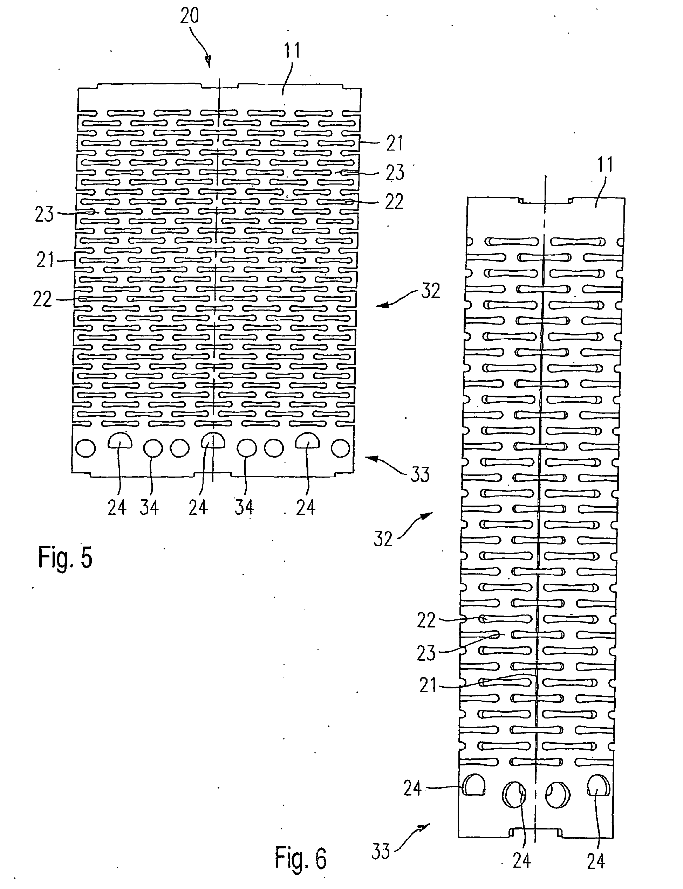

Die Rohrfeder 11 wird dabei wie in den Fig. 2 und 5 für zwei verschiedene Ausführungsbeispiele dargestellt hergestellt. Zunächst wird durch Stanzen aus einer Platine 20 eine Grundform hergestellt, welche, wie in Fig. 6 für das zweite Ausführungsbeispiel dargestellt, rundgebogen wird. In einem Stoßbereich, in welchem Kanten 21 der Rohrfeder 1 nebeneinander liegen, werden diese durch Längsschweißen miteinander verbunden, so daß ein geschlossenes Rohr entsteht.

Bei der Herstellung der Grundform werden in die Platine 20 Ausnehmungen 22 eingebracht. Die Ausnehmungen 22 sind dabei regelmäßig über einen Teil der Fläche der Rohrfeder 11 verteilt, wobei die Ausnehmungen 22 annäherungsweise achtförmig ausgebildet sind. Die Ausnehmungen 22 sind durch Stanzen oder ähnliche Verfahren hergestellt. Zwischen den Ausnehmungen 22 bleiben durch den Bearbeitungsprozeß Stege 23 stehen, welche die stützende, aber federnde Wirkung der Rohrfeder 11 ausmachen. Durch die achtförmige Form der Ausnehmungen 22 ist die Rohrfeder 11 in ihrer axialen Ausdehnung flexibel, sie kann leicht gezogen oder gestaucht werden. Die Federkonstante der Rohrfeder 11 wird dabei durch die Anzahl, Form, Größe und Anordnung der Ausnehmungen 22 beeinflußt.

Gemäß dem in Fig. 2 dargestellten ersten Ausführungsbeispiel sind die Ausnehmungen 22 in einem mittleren Bereich 32 der Rohrfeder ausgebildet, während Endbereiche 33 frei von den Ausnehmungen 22 bleiben und abgesehen von weiter unten näher beschriebenen Montageeingriffen 24 eine geschlossene Fläche aufweisen. In dem in den Fig. 5 und 6 dargestellten zweiten Ausführungsbeispiel sind die Ausnehmungen 22 sowohl in dem mittleren Bereich 32 als auch in einem der Endbereiche 33 ausgebildet.

Erfindungsgemäß sind Montageeingriffe 24 vorgesehen, welche für die Montage des Aktors 10 in der Rohrfeder 11 benötigt werden. Die Montageeingriffe 24 sind bei dem in Fig.. 2 dargestellten ersten Ausführungsbeispiel in beiden Endbereichen 33 der Rohrfeder 11 vorgesehen, während gemäß dem in den Fig. 5 und 6 dargestellten zweiten Ausführungsbeispiel lediglich in einem der Endbereiche 33 Montageeingriffe 24 ausgebildet sind. Dadurch ist der Bereich, in welchem die Ausnehmungen 22 ausgebildet sind, größer, wodurch die Rohrfeder 11 elastischer wird.

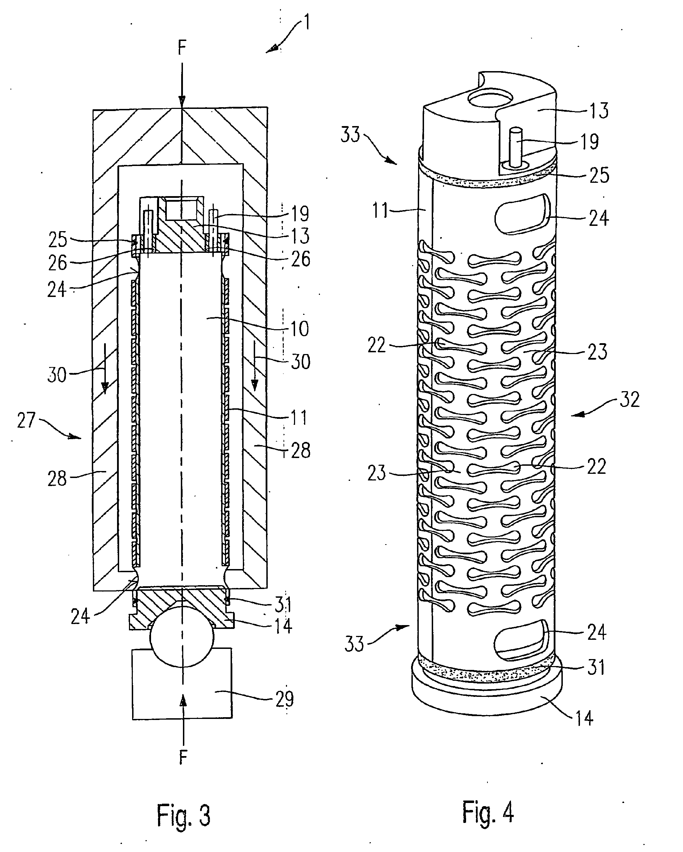

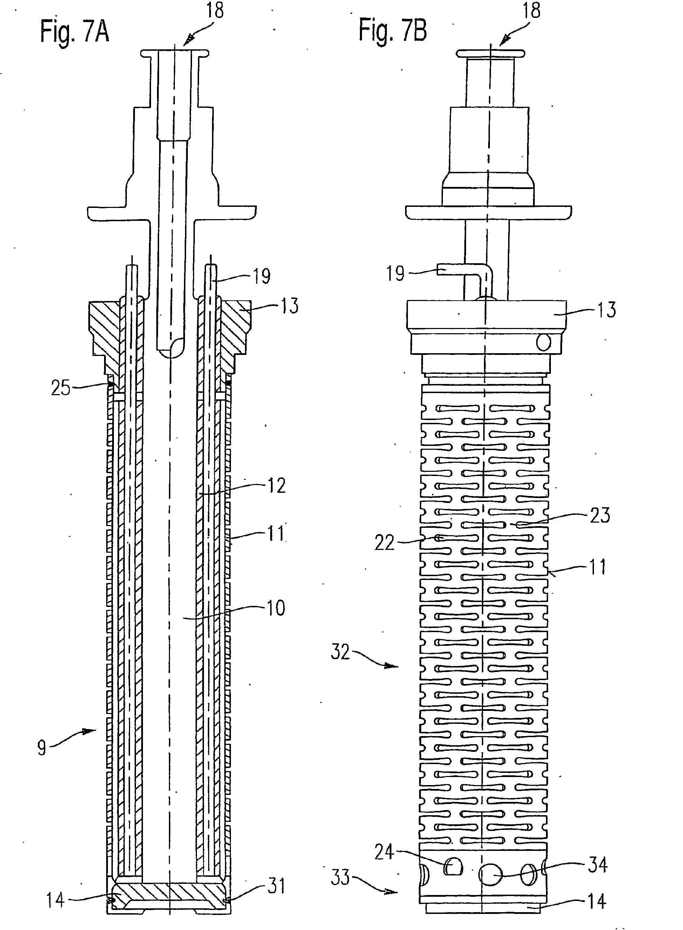

Wie aus dem in Fig. 2 dargestellten ersten Ausführungsbeispiel ersichtlich, sind die Montageeingriffe 24 hier zur gleichmäßigen Krafteinleitung zumindest paarig einander gegenüberliegend vorgesehen. In dem in den Fig. 5 und 6 dargestellten zweiten Ausführungsbeispiel sind dagegen zumindest drei Montageeingriffe 24 vorhanden, welche äquidistant in gleichen Winkelabständen über den Umfang der Rohrfeder 11 verteilt sind. Zwischen den Montageeingriffen 24 können weitere Ausnehmungen 34 vorgesehen sein, welche die Rohrfeder 11 ebenso wie die zusätzliche Anzahl von Ausnehmungen 22 weicher machen und dadurch einen größeren Hub des Aktors 10 ermöglichen. Die Funktion der Montageeingriffe 24 wird in der Beschreibung zu den Fig. 3 bzw. 7A und 7B näher erläutert.

In Fig. 3 ist die Montage des Aktors 10 in einer Rohrfeder 11 gemäß Fig. 2 dargestellt.

Die Montage des Aktors 10 in der Rohrfeder 11 erfolgt vorteilhafterweise so, daß eine Vorspannung durch eine kraftgesteuerte Wegeverstellung in dem Aktormodul 9 erzeugt wird. Trotz Fertigungs- und Steifigkeitstoleranzen kann die Vorspannkraft ohne Verwendung weiterer Bauteile sehr genau eingestellt werden. Die Verschweißung des Aktorkopfes 14 und des Aktorfußes 13 mit der Rohrfeder 11 kann dabei in einem durch die Vorspannkraft unbelasteten Bereich erfolgen, wodurch die Verschweißung spannungsfrei hergestellt werden kann und eine erheblich bessere Haltbarkeit aufweist. Dies wird durch die Steifigkeit der Rohrfeder 11 im Bereich der Montageeingriffe 24 ermöglicht.

Die Montage erfolgt dabei in folgender Reihenfolge. Zunächst wird die Rohrfeder 11 auf den Aktorfuß 13 gefügt und mittels einer ersten Schweißnaht 25 mit diesem verschweißt. Danach wird der Aktor 10 in die Rohrfeder 11 eingeführt. Während der Aktor 10 in Anlage an dem Aktorfuß 13 gehalten wird, werden Zentrierpins 26 zwischen den elektrischen Leitungen 19 und der Rohrfeder 11 eingesetzt, um den Aktor 10 in der Rohrfeder 11 zu zentrieren. Nun wird der Aktorkopf 14 eingesetzt und so weit in die Rohrfeder 11 eingeschoben, bis er an dem Aktor 10 anliegt.

Das solchermaßen vormontierte Aktormodul 9 ist bereits problemlos transportfähig, da der empfindliche Aktor 10 in der Rohrfeder 11 angeordnet und vor Scherkräften geschützt ist.

Das Aktormodul 9 wird in eine Montageeinrichtung 27 eingesetzt, welche in Fig. 3 schematisch dargestellt ist. Dabei greifen Spannzangen 28 in die abströmseitigen Montageeingriffe 24 der Rohrfeder 11 ein. Am Aktorkopf 14 liegt eine Kraftmeßdose 29 an.

Die Kraftmeßdose 29 wird zunächst kalibriert, dann werden die Spannzangen 28 mit der Rohrfeder 11 in Richtung auf die Kraftmeßdose 29 verschoben, wie durch die Pfeile 30 angedeutet. Die Kraft F, mit welcher die Rohrfeder 11 gegen den Aktorkopf 14 gedrückt wird, ist dabei zu jedem Zeitpunkt direkt an der Kraftmeßdose 29 ablesbar. Die Rohrfeder 11 kann nun so lange verschoben werden, bis die gewünschte Vorspannung auf den Aktor 10 erreicht ist. Der Betrag der Kraft richtet sich dabei nach den Anforderungen an den Hub des Aktors 10 sowie die gewünschte Ansteuercharakteristik. Mittels einer geeigneten Gestaltung der Rohrfeder 11 kann auch eine progressive Federkonstante erzielt werden.

Abschließend wird die Rohrfeder 11 mit dem Aktorkopf 14 über eine zweite Schweißnaht 31 verschweißt. Der Kraftfluß in der Rohrfeder 11 verläuft dabei so, daß alle später unter Last stehenden Bauteile auch beim Vorspannen belastet werden. Nur der Endbereich 33 der Rohrfeder 11, in welchem die Montageeingriffe 24 ausgebildet sind, liegt nicht im Kraftfluß, so daß die zweite Schweißnaht 31 in spannungslosem Zustand hergestellt werden kann.

Fig. 4 zeigt das fertig montierte Aktormodul 9. Die Rohrfeder 11 ist über die Schweißnähte 25 und 31 mit dem Aktorfuß 13 und dem Aktorkopf 14 verschweißt. Die mdntageeingriffe 24 werden zwar nur in dem dem Aktorkopf 14 näherliegenden Endbereich 33 der Rohrfeder 11 benötigt, sollten jedoch, wie auch in Fig. 2 und 3 dargestellt, sowohl aus Gründen der Symmetrie zur Vermeidung der Verfälschung der Federcharakteristik als auch aus Kostengründen an beiden Enden der Rohrfeder 11 angebracht werden.

In Fig. 7A und 7B ist ein fertig montiertes Aktormodul 9 mit einer Rohrfeder 11 gemäß Fig. 6 in einer geschnittenen und einer seitlichen Ansicht dargestellt.

Das Verfahren zur Montage umfaßt für eine Rohrfeder 11 gemäß dem in den Fig. 5 bis 7 dargestellten zweiten Ausführungsbeispiel folgende Montageschritte: zunächst wird der Aktor 10 auf einen mit einem Aktorfuß 13 verbundenen Brennstoffzulauf 18 gefügt. Die Rohrfeder 11 wird dann ebenfalls auf den Aktorfuß 13 gefügt und mit diesem spannungslos über eine erste Schweißnaht 25 verbunden. Die Rohrfeder 11 wird nun durch Zug an den Montageeingriffen 24 vorgespannt. Dabei wird die Rohrfeder 11 zunächst über die benötigte Zugkraft hinaus überdehnt. Anschließend wird die Zugkraft auf die benötigte Zugkraft von ca. 600 N reduziert.

Abschließend wird die Rohrfeder 11 mit dem Aktorkopf 14 über eine zweite Schweißnaht 31 verschweißt. Der Kraftfluß in der Rohrfeder 11 verläuft dabei so, daß alle später unter Last stehenden Bauteile auch beim Vorspannen belastet werden. Nur der Endbereich 33 der Rohrfeder 11, in welchem die Montageeingriffe 24 ausgebildet sind, liegt nicht im Kraftfluß, so daß die zweite Schweißnaht 31 in spannungslosem Zustand hergestellt werden kann.

Die Erfindung ist nicht auf die dargestellten Ausführungsbeispiele beschränkt und insbesondere bei einer Vielzahl von Bauweisen von Brennstoffeinspritzventilen anwendbar. Auch sind alle Merkmale des Ausführungsbeispiels beliebig miteinander kombinierbar.

## Patentansprüche

1. Rohrfeder (11) für einen piezoelektrischen oder magnetostriktiven Aktor (10), welcher insbesondere zur Betätigung eines Brennstoffeinspritzventils (1) für Brennstoffeinspritzanlagen von Brennkraftmaschinen dient, wobei die Rohrfeder (11) Montageeingriffe (24) aufweist,
**dadurch gekennzeichnet,**
**dass** die Rohrfeder (11) durch Zug an den Montageeingriffen (24) über diese vorspannbar ist.

2. Rohrfeder nach Anspruch 1,
**dadurch gekennzeichnet,**
**dass** die Rohrfeder (11) in einem mittleren Bereich (32) Ausnehmungen (22) und dazwischenliegende Stege (23) aufweist..

3. Rohrfeder nach Anspruch 1 oder 2,
**dadurch gekennzeichnet,**
**dass** die Montageeingriffe (24) in beiden Endbereichen (33) der Rohrfeder(11) ausgebildet sind.

4. Rohrfeder nach Anspruch 3,
**dadurch gekennzeichnet,**
**dass** in jedem der Endbereiche (33) zumindest zwei Montageeingriffe (24) vorgesehen sind.

5. Rohrfeder nach Anspruch 4,
**dadurch gekennzeichnet,**
**dass** die Montageeingriffe (24) paarig einander gegenüberliegend angeordnet sind.

6. Rohrfeder nach Anspruch 1 oder 2,
**dadurch gekennzeichnet,**
**dass** die Montageeingriffe (24) nur in einem der Endbereiche (33) der Rohrfeder (11) ausgebildet sind.

7. Rohrfeder nach Anspruch 6,
**dadurch gekennzeichnet,**
**dass** der zweite Endbereich (33) mit Ausnehmungen (22) und Stegen (23) wie der mittlere Bereich (32) versehen ist.

8. Rohrfeder nach Anspruch 6 oder 7,
**dadurch gekennzeichnet,**
**dass** zumindest drei Montageeingriffe (24) vorgesehen sind.

9. Rohrfeder nach Anspruch 8,
**dadurch gekennzeichnet,**
**dass** die zumindest drei Montageeingriffe (24) in gleichmäßigen Winkelabständen in der Rohrfeder (11) angeordnet sind.

10. Rohrfeder nach Anspruch 9,
**dadurch gekennzeichnet,**
**dass** zwischen den Montageeingriffen (24) weitere Ausnehmungen ausgebildet sind.

11. Rohrfeder nach einem der Ansprüche 1 bis 10,
**dadurch gekennzeichnet,**
**dass** die Rohrfeder (11) mit einem Aktorkopf (14) und einem Aktorfuß (13) verbunden ist.

12. Rohrfeder nach Anspruch 11,
**dadurch gekennzeichnet,**
**dass** die Verbindung über Schweißnähte (25; 31) erfolgt.

13. Verfahren zur Montage einer Rohrfeder (11) für einen piezoelektrischen oder magnetostriktiven Aktor (10), welcher
insbesondere zur Betätigung eines Brennstoffeinspritzventils (1) für Brennstoffeinspritzanlagen von Brennkraftmaschinen. dient, wobei die Rohrfeder(11) zumindest zwei Montageeingriffe (24) aufweist,
wobei das Verfahren folgende Montageschritte umfasst:
- Vormontieren eines aus dem Aktor (10), der Rohrfeder (11), einem Aktorfuß (13) und einem Aktorkopf (14) bestehenden Aktormoduls (9),
- Einsetzen des vormontierten Aktormoduls (9) in eine Montagevorrichtung (27), und
- Vorspannen und Endmontieren des Aktormoduls (9)
**dadurch gekennzeichnet,**
**dass** der zweite Verfahrensschritt folgende Teilschritte umfasst:
- Einsetzen des vormontierten Aktormoduls (9) in die Montageeinrichtung (27),
- Ansetzen von Spannzangen (28) in die Montageeingriffe (24) der Rohrfeder (11) und einer Kraftmessdose (29) am Aktorkopf (14), und
- Kalibrieren der Kraftmessdose (29).

14. Verfahren nach Anspruch 13,
**dadurch gekennzeichnet,**
**dass** der erste Verfahrensschritt folgende Teilschritte umfasst:
- Fügen der Rohrfeder (11) auf den Aktorfuß (13),
- Verschweißen der Rohrfeder(11) mit dem Aktorfuß (13) mittels einer ersten Schweißnaht (25),
- Einführen des Aktors (10) in die Rohrfeder (11), - Halten des Aktors (10) in Anlage am Aktorfuß (13),
- Einsetzen von Zentrierpins(26) zwischen im Aktorfuß (13) angeordneten elektrischen Leitungen (19) und der Rohrfeder (11), und
- Einsetzen des Aktorkopfes (14) und Einschieben in die Rohrfeder (11), bis der Aktorkopf (14) am Aktor(10) anliegt.

15. Verfahren nach einem der Ansprüche 13 bis 14,
**dadurch gekennzeichnet,**
**dass** der dritte Verfahrensschritt folgende Teilschritte umfasst:
- Verschieben der Spannzangen (28) mit der Rohrfeder (11) in Richtung auf die Kraftmessdose (29),
- Ablesen der Kraft an der Kraftmessdose (29),
- Verschweißen der Rohrfeder (11) mit dem Aktorkopf (14) mittels einer zweiten Schweißnaht (31).

16. Verfahren zur Montage einer Rohrfeder (11) für einen piezoelektrischen oder magnetostriktiven Aktor (10), welcher insbesondere zur Betätigung eines Brennstoffeinspritzventils (1) für Brennstoffeinspritzanlagen von Brennkraftmaschinen dient, wobei die Rohrfeder (11) zumindest zwei Montageeingriffe (24) aufweist,
**dadurch gekennzeichnet,**
**dass** das Verfahren folgende Montageschritte umfasst:
- Fügen des Aktors (10) auf einen mit einem Aktorfuß (13) verbundenen Brennstoffzulauf (18),
- Fügen und Verschweißen der Rohrfeder (11) auf dem Aktorfuß (13) über eine erste Schweißnaht (25),
- Vorspannen der Rohrfeder (11) durch Zug an den Montageeingriffen (24) und
- Fügen und Verschweißen der vorgespannten Rohrfeder (11) auf einem Aktorkopf (14) über eine zweite Schweißnaht (31).

17. Verfahren nach Anspruch 16,
**dadurch gekennzeichnet,**
**dass** die Rohrfeder (11) zunächst über die nötige Zugkraft hinaus überdehnt wird und anschließend die Zugkraft auf die nötige Zugkraft reduziert wird.

18. Verfahren nach Anspruch 17,
**dadurch gekennzeichnet,**
**dass** die benötigte Zugkraft ca. 600 N beträgt.

## Claims

1. Tube spring (11) for a piezoelectric or magnetostrictive actuator (10) which serves in particular to actuate a fuel injection valve (1) for fuel injection systems of internal combustion engines, the tube spring (11) having assembly engagement apertures (24),
**characterized**
**in that** the tube spring (11) can be preloaded by means of the assembly engagement apertures (24) by applying tension at said engagement apertures (24).

2. Tube spring according to Claim 1,
**characterized**
**in that**, in a central region (32), the tube spring (11) has recesses (22) and webs (23) situated in between said recesses (22).

3. Tube spring according to Claim 1 or 2,
**characterized**
**in that** the assembly engagement apertures (24) are formed in both end regions (33) of the tube spring (11).

4. Tube spring according to Claim 3,
**characterized**
**in that** at least two assembly engagement apertures (24) are provided in each of the end regions (33).

5. Tube spring according to Claim 4,
**characterized**
**in that** the assembly engagement apertures (24) are arranged opposite one another in pairs.

6. Tube spring according to Claim 1 or 2,
**characterized**
**in that** the assembly engagement apertures (24) are formed in only one of the end regions (33) of the tube spring (11).

7. Tube spring according to Claim 6,
**characterized**
**in that** the second end region (33) is provided with recesses (22) and webs (23) like the central region (32).

8. Tube spring according to Claim 6 or 7,
**characterized**
**in that** at least three assembly engagement apertures (24) are provided.

9. Tube spring according to Claim 8,
**characterized**
**in that** the at least three assembly engagement apertures (24) are arranged in the tube spring (11) with uniform angular spacing.

10. Tube spring according to Claim 9,
**characterized**
**in that** further recesses are formed between the assembly engagement apertures (24).

11. Tube spring according to one of Claims 1 to 10,
**characterized**
**in that** the tube spring (11) is connected to an actuator head (14) and an actuator base (13).

12. Tube spring according to Claim 11,
**characterized**
**in that** the connection is provided by means of weld seams (25; 31).

13. Method for assembling a tube spring (11) for a piezoelectric or magnetostrictive actuator (10) which serves in particular to actuate a fuel injection valve (1) for fuel injection systems of internal combustion engines, the tube spring (11) having at least two assembly engagement apertures (24), the method comprising the following assembly steps:
- pre-assembling an actuator module (9) composed of the actuator (10), the tube spring (11), an actuator base (13) and an actuator head (14),
- inserting the pre-assembled actuator module (9) into an assembly device (27), and
- pre-loading and performing final assembly of the actuator module (9),
**characterized**
**in that** the second method step comprises the following sub-steps:
- inserting the pre-assembled actuator module (9) into the assembly device (27),
- placing clamping tongs (28) into the assembly engagement apertures (24) of the tube spring (11) and a load cell (29) onto the actuator head (14), and
- calibrating the load cell (29).

14. Method according to Claim 13,
**characterized**
**in that** the first method step comprises the following sub-steps:
- joining the tube spring (11) to the actuator base (13),
- welding the tube spring (11) to the actuator base (13) by means of a first weld seam (25),
- inserting the actuator (10) into the tube spring (11),
- holding the actuator (10) in contact with the actuator base (13),
- inserting centring pins (26) between electrical lines (19), which are arranged in the actuator base (13), and the tube spring (11), and
- inserting the actuator head (14) and pushing it into the tube spring (11) until the actuator head (14) bears against the actuator (10).

15. Method according to one of claims 13 to 14,
**characterized**
**in that** the third method step comprises the following sub-steps:
- displacing the clamping tongs (28) with the tube spring (11) in the direction of the load cell (29),
- reading off the force on the load cell (29),
- welding the tube spring (11) to the actuator head (14) by means of a second weld seam (31).

16. Method for assembling a tube spring (11) for a piezoelectric or magnetostrictive actuator (10) which serves in particular to actuate a fuel injection valve (1) for fuel injection systems of internal combustion engines, the tube spring (11) having at least two assembly engagement apertures (24),
**characterized**
**in that** the method comprises the following assembly steps:
- joining the actuator (10) to a fuel supply (18) which is connected to an actuator base (13),
- joining and welding the tube spring (11) to the actuator base (13) by means of a first weld seam (25),
- preloading the tube spring (11) by applying tension at the assembly engagement apertures (24), and
- joining and welding the preloaded tube spring (11) to an actuator head (14) by means of a second weld seam (31).

17. Method according to Claim 16,
**characterized**
**in that** the tube spring (11) is initially overstretched beyond the required tensile force and the tensile force is subsequently reduced to the required tensile force.

18. Method according to Claim 17,
**characterized**
**in that** the required tensile force is approximately 600 N.

## Revendications

1. Tube-ressort (11) pour un actionneur piézoélectrique ou magnétostrictif (10), en particulier pour actionner un injecteur de carburant (1) d'installations d'injection de carburant de moteurs à combustion interne, le tube-ressort (11) présentant des prises de montage (24),
**caractérisé en ce que**
le tube-ressort (11) peut être précontraint par les prises de montage (24) par traction sur celles-ci.

2. Tube-ressort selon la revendication 1,
**caractérisé en ce que**
dans une zone centrale (32) le tube-ressort (11) présente des évidements (22) et des nervures (23) situées entre ceux-ci.

3. Tube-ressort selon la revendication 1 ou 2,
**caractérisé en ce que**
les prises de montage (24) sont formées dans les deux zones d'extrémité (33) du tube-ressort (11).

4. Tube-ressort selon la revendication 3,
**caractérisé en ce que**
chaque zone d'extrémité (33) comporte au moins deux prises de montage (24).

5. Tube-ressort selon la revendication 4,
**caractérisé en ce que**
les prises de montage (24) sont disposées par paires tournées les unes vers les autres.

6. Tube-ressort selon la revendication 1 ou 2,
**caractérisé en ce que**
les prises de montage (24) ne sont formées que dans l'une des zones d'extrémité (33) du tube-ressort (11).

7. Tube-ressort selon la revendication 6,
**caractérisé en ce que**
la deuxième zone d'extrémité (33) est munie d'évidements (22) et de nervures (23) comme la zone centrale (32).

8. Tube-ressort selon la revendication 6 ou 7,
**caractérisé par**
au moins trois prises de montage (24).

9. Tube-ressort selon la revendication 8,
**caractérisé en ce qu'**
au moins trois prises de montage (24) sont disposées à des distances angulaires régulières dans le tube-ressort (11).

10. Tube-ressort selon la revendication 9,
**caractérisé en ce que**
d'autres évidements sont formés entre les prises de montage (24).

11. Tube-ressort selon l'une quelconque des revendications 1 à 10,
**caractérisé en ce que**
le tube-ressort (11) est relié à une tête d'actionneur (14) et à un pied d'actionneur (13).

12. Tube-ressort selon la revendication 11,
**caractérisé en ce que**
la liaison est assurée par des soudures (25 ; 31).

13. Procédé de montage d'un tube-ressort (11) pour un actionneur piézoélectrique ou magnétostrictif (10), en particulier pour actionner un injecteur de carburant (1) d'installations d'injection de carburant de moteurs à combustion interne, le tube-ressort (11) présentant au moins deux prises de montage (24) et le procédé comprenant les étapes de montage suivantes :
- prémontage d'un module d'actionneur (9) composé de l'actionneur (10), du tube-ressort (11), d'un pied d'actionneur (13) et d'une tête d'actionneur (14),
- insertion du module d'actionneur (9) prémonté dans un dispositif de montage (27), et
- précontrainte et montage final du module d'actionneur (9),
**caractérisé en ce que**
la deuxième étape de procédé comprend les étapes partielles suivantes :
- insertion du module d'actionneur (9) prémonté dans le dispositif de montage (27),
- mise en place de pinces de serrage (28) dans les prises de montage (24) du tube-ressort (11) et d'une boîte dynamométrique (29) sur la tête d'actionneur (14), et
- calibrage de la boîte dynamométrique (29).

14. Procédé selon la revendication 13,
**caractérisé en ce que**
la première étape de procédé comprend les étapes partielles suivantes :
- ajustage du tube-ressort (11) sur le pied d'actionneur (13),
- soudage du tube-ressort (11) avec le pied d'actionneur (13) au moyen d'une première soudure (25),
- introduction de l'actionneur (10) dans le tube-ressort (11),
- maintien de l'actionneur (10) en butée contre le pied d'actionneur (13),
- insertion de fiches de centrage (26) entre des lignes électriques (19) disposées dans le pied d'actionneur (13) et le tube-ressort (11), et
- insertion de la tête d'actionneur (14) et coulissement dans le tube-ressort (11) jusqu'à ce que la tête d'actionneur (14) arrive en butée contré l'actionneur (10).

15. Procédé selon l'une quelconque des revendications 13 à 14,
**caractérisé en ce que**
la troisième étape de procédé comprend les étapes partielles suivantes :
- déplacement des pinces de serrage (28) avec le tube-ressort (11) en direction de la boîte dynamométrique (29),
- lecture de la force sur la boîte dynamométrique (29),
- soudage du tube-ressort (11) avec la tête d'actionneur (14) au moyen d'une deuxième soudure (31).

16. Procédé de montage d'un tube-ressort (11) pour un actionneur piézoélectrique ou magnétostrictif (10), en particulier pour actionner un injecteur de carburant (1) d'installations d'injection de carburant de moteurs à combustion interne, le tube-ressort (11) présentant au moins deux prises de montages,
**caractérisé en ce que**
le procédé présente les étapes de montage suivantes :
- ajustage de l'actionneur (10) sur une admission de carburant (18) reliée à un pied d'actionneur (13),
- ajustage et soudage du tube-ressort (11) sur le pied d'actionneur (13) par une première soudure (25),
- précontrainte du tube-ressort (11) par traction aux prises de montage (24), et
- ajustage et soudage du tube-ressort (11) précontraint sur une tête d'actionneur (14) par une deuxième soudure (31).

17. Procédé selon la revendication 16,
**caractérisé en ce que**
le tube-ressort (11) est d'abord étendu au-delà de la force de traction nécessaire, puis la force de traction est réduite à la force de traction nécessaire.

18. Procédé selon la revendication 17,
**caractérisé en ce que**
la force de traction nécessaire s'élève à 600 N environ.
